Europäisches Patentamt

European Patent Office

Office européen des brevets

(19)

(11) Veröffentlichungsnummer: **0 062 135
B1**

# (12) EUROPÄISCHE PATENTSCHRIFT

(45) Veröffentlichungstag der Patentschrift:
**24.06.87**

(51) Int. Cl.⁴: **H 05 K 5/06,** H 05 K 7/18

(21) Anmeldenummer: **82100363.9**

(22) Anmeldetag: **20.01.82**

(54) **Spritzwassergeschützter Kasten für elektrische Geräte, wie Automaten, Sicherungen, Klemmen, Stromzähler und dergl.**

(30) Priorität: **31.03.81 DE 3112675**

(43) Veröffentlichungstag der Anmeldung:
**13.10.82 Patentblatt 82/41**

(45) Bekanntmachung des Hinweises auf die Patenterteilung:
**24.06.87 Patentblatt 87/26**

(84) Benannte Vertragsstaaten:
**AT BE CH FR GB IT LI NL SE**

(56) Entgegenhaltungen:
**EP - A - 0 053 050
BE - A - 863 973
DE - A - 1 625 369
GB - A - 2 033 874
GB - A - 2 036 449**

(73) Patentinhaber: **Günther Spelsberg GmbH & Co. KG,
Jahnstrasse 7, D-5885 Schalksmühle (DE)**

(72) Erfinder: **Spelsberg, Eckhard, Dipl.-Ing., Löherweg 36,
D-5885 Schalksmühle (DE)**
Erfinder: **Keilholz, Otto, Jägerstrasse 7,
D-5885 Schalksmühle (DE)**

(74) Vertreter: **Buse, Karl Georg, Dipl.-Phys. et al,
Patentanwälte Dipl.-Phys. Buse Dipl.-Phys. Mentzel
Dipl.-Ing. Ludewig Unterdörnen 114,
D-5600 Wuppertal 2 (DE)**

## Beschreibung

Die Erfindung betrifft einen spritzwassergeschützten Kasten für elektrische Geräte, wie Automaten, Sicherungen, Klemmen und Stromzähler, der in Feuchträumen, wie Garagen und Waschanlagen installierbar ist und im wesentlichen aus einem Kastenunterteil und einem Deckelteil besteht, wobei diese Kastenteile an der Verbindungsfuge mit Dichtleisten und Dichtungen ineinandergreifen.

Derartige, zur Installation in Feuchträumen verwendbare Kästen für elektrische Geräte sind in mannigfachen Formen und Abmessungen bekannt und lassen sich zu grösseren Raumeinheiten zusammenstellen, um die je nach Erfordernissen notwendige Anzahl elektrischer Geräte spritzwassergeschützt aufzunehmen. Dabei handelt es sich jedoch immer um Einzelkästen verschiedener Grösse, wobei die Geräteaufnahme der Einzelkästen beschränkt ist und demnach je nach der benötigten Anzahl elektrischer Geräte eine Vielzahl von Kästen zu einer flächendeckenden Einheit zusammengesetzt werden. Die bestehenden Normvorschriften der Elektroindustrie staffeln jedoch den Flächenplatzbedarf, so dass verschieden grosse Kästen zu der benötigten Gesamteinheit zusammengestellt werden müssen. Zur Bildung solcher Kasteneinheiten hat das Bauprogramm eine Vielzahl unterschiedlicher Kästen zu umfassen, so dass von daher eine grosse Anzahl von Werkzeugen zur Herstellung der aus Isolierstoff, vorzugsweise aus einem Kunststoff, zu spritzenden Flächen erforderlich ist. Die in ihrer Summe demnach beträchtlichen Werkzeugkosten verteuern die Kästen in hohem Masse. Gleichfalls ergeben sich durch die Lagerhaltung der Vielzahl unterschiedlicher Kästen erhebliche Lagerkosten.

Aus der GB-A 2 036 449 ist beispielsweise ein solcher, elektrische Geräte spritzwassergeschützt aufnehmender Kasten ersichtlich, dessen Deckelteil mit dem Kastenunterteil durch Verbindungsklammern verbunden ist. Bei diesem Kasten lässt sich jedoch das Raumangebot nicht vergrössern.

Die weiterhin vorbekannte BE-A 863 973 offenbart zwar einen in seiner Grösse wandelbaren, aus Endstücken und Zwischenstücken zusammengesetzten Kastenteil, wobei jedoch einerseits Elemente zur Erzielung eines Spritzwasserschutzes fehlen und andererseits auf eine Abdeckung des Kastenteiles in spritzwasserdichter Verbindung nicht hingewiesen wird. Ausserdem wird mit dieser Lösung kein stabiler Zusammenhalt der Kastenteile mit kasteneigenen Bauteilen erzielt.

Die Aufgabe der vorliegenden Erfindung besteht darin, einen Kasten der eingangs genannten Art zu schaffen, der vom Raumangebot her für die aufzunehmenden elektrischen Geräte aus wenigen gleichen Bauteilen variabel gestaltet werden kann und einen sicheren Zusammenhalt der einzelnen Bauteile untereinander gewährleistet.

Diese Aufgabe ist erfindungsgemäss mit den im Kennzeichen des Anspruches 1 genannten Merkmalen gelöst. Abgesehen davon, dass mit den Klammerelementen eine vollständige Abdeckung des Verbindungsbereiches gewährleistet ist, wirken diese Klammerelemente neben ihrer Verbindungserstellung ausserdem noch stabilisierend. Für jeden Kastenunterteil sind zwei Endstücke notwendig, die durch eine beliebige Anzahl von Zwischenstücken zu einem in seiner Aufnahmegrösse zu einem dem Bedarfsfall anpassbaren Kastenunterteil erweiterungsfähig ist. Der Deckelteil zum Verschliessen des die elektrischen Geräte aufnehmenden Kastenunterteiles ist ebenfalls aus wenigstens zwei Endschalen und aus Zwischenschalen bildbar, wobei die Anzahl der Zwischenschalen derart gewählt werden kann, dass der Deckelteil in der Grösse mit dem gewählten Kastenunterteil übereinstimmt. Kastendeckelteil und Kastenunterteil lassen sich dann beispielsweise auf bekannte, herkömmliche Weise abgedichtet miteinander verbinden. Der kleinstmögliche Kasten würde demnach aus zwei Endstücken und einer Verbindungsklammer für das Kastenunterteil und aus zwei Endschalen und Klammerverbindern für den Deckelteil bestehen. Die Endstücke und die Endschalen sind dabei so ausgebildet, dass sie einander gleich sind und durch das gewendete Aneinanderfügen des einen Endstücks an das andere bzw. der einen Endschale an die andere spiegelbildlich aneinanderpassen. Demzufolge sind für den aus Endstücken und Endschalen gebildeten, kleinstmöglichen Kasten lediglich zwei Grundwerkzeuge erforderlich. Ausser diesen beiden Grundwerkzeugen sind noch zwei weitere Werkzeuge erforderlich, und zwar für eine Verbindungsklammer und einen Klammerverbinder. Dabei versteht es sich, dass noch Verbindungsmittel einzusetzen sind, um den zusammengesetzten Kastenunterteil und den zusammengesetzten Deckelteil miteinander zu verbinden. Diese Verbindungsmittel könnten bekannter, herkömmlicher Art sein oder in der unten beschriebenen Weise gestaltet sein. Dieser Kasten ist jedoch beliebig erweiterungsfähig, indem zwischen die Endstücke des Kastenunterteiles und die Endschalen des Deckelteiles eine dem Bedarfsfall beliebig anpassbare Anzahl von Zwischenstücken und Zwischenschalen geschaltet ist. Für die Zwischenstücke und die Zwischenschale werden jedoch nur noch zwei weitere Werkzeuge benötigt, unabhängig davon, welche Kastengrösse herzustellen ist. Damit ist einerseits sowohl die Lagerung der Werkzeuge als auch die Lagerhaltung von Bauteilen wesentlich vereinfacht, und andererseits ist mit wenigen Werkzeugen das gesamte Kastenbauprogramm abzudecken.

Weitere vorteilhafte Ausgestaltungen der Erfindung ergeben sich mit den in den Unteransprüchen genannten Merkmalen.

Die Erfindung ist in Ausführungsbeispielen auf der Zeichnung dargestellt und wird nachfolgend näher erläutert. Es zeigen:

Fig. 1 den aus Endstücken und Endschalen gebildeten Kasten in einer Draufsicht auf den Kastenunterteil,

Fig. 2 den aus Fig. 1 ersichtlichen Kasten bei abgenommenem Deckelteil in einer Draufsicht auf den Kastenunterteil,

Fig. 3 den aus den Fig. 1 und 2 ersichtlichen Kasten in einer Ansicht auf eine Einführöffnungen grossen Durchmesser aufweisende Schmalseite,

Fig. 4 den aus Fig. 1 ersichtlichen Kasten in einer Ansicht auf die eine Vielzahl kleiner Einführröffnungen aufweisende Schmalseite,

Fig. 5 den erfindungsgemässen Kasten in einer Draufsicht auf den Deckelteil, der aus zwei Endschalen und zwei Zwischenschalen gebildet ist und im Bereich der drei Trennfugen des Deckelteiles jeweils eine durch eine durchsichtige Klappe abdeckbare Sichtöffnung aufweist,

Fig. 6 ein Endstück des Kastenunterteiles in einer Unteransicht,

Fig. 7 das Endstück des Kastenunterteiles in einer Ansicht auf das Kasteninnere gesehen,

Fig. 8 das Kastenendstück in einer Draufsicht auf die Innenseite des Endstücks,

Fig. 9 ein Zwischenstück des Kastenunterteiles, dessen linke Seite in einer Ansicht in den Kastenunterteil hineingesehen ist, während dessen rechte Hälfte als Ansicht von der Unterseite her gesehen, dargestellt ist,

Fig. 10 das Zwischenstück des Kastenunterteiles in einer Ansicht auf die Querschnittform,

Fig. 11 die Stosswandungen im Trennfugenbereich zweier Endstücke bzw. eines Endstücks und eines Zwischenstücks oder zwischen zwei Zwischenstücken, in einem gegenüber den Fig. 6

Fig. 12 eine zwei Endstücke bzw. ein Endstück mit einem Zwischenstück oder zwei Zwischenstücke zusammenfügende Verbindungsklammer im Halbschnitt,

Fig. 13 die aus Fig. 12 ersichtliche Verbindungsklammer in einer Draufsicht,

Fig. 14 die Verbindungsklammer in einem Schnitt nach der Linie XIV–XIV von Fig. 13,

Fig. 15 eine Endschale des Deckelteiles in einer Draufsicht auf das Innere der Endschale,

Fig. 16 die Endschale in einer Ansicht in deren Innenraum,

Fig. 17 die Endschale in einer Draufsicht,

Fig. 18 eine Zwischenschale des Deckelteiles in einer Draufsicht auf deren Innenraum gesehen,

Fig. 19 die Zwischenschale in einer Ansicht in Richtung auf den Innenraum,

Fig. 20 die Zwischenschale in einer Draufsicht auf deren Aussenseite gesehen,

Fig. 21 einen die Endschalen bzw. eine Endschale und eine Zwischenschale oder zwei Zwischenschalen zusammenhaltenden U-förmigen Klammerverbinder in einer Ansicht auf die Stirnseiten seiner Schenkel,

Fig. 22 den Klammerverbinder in einem Schnitt nach der Linie XXII–XXII von Fig. 21,

Fig. 23 einen Schnellverbindungskopfbolzen in einem ausgebrochenen Schnitt,

Fig. 24 den Schnellverbindungskopfbolzen in einer um 90° gedrehten Lage,

Fig. 25 die Verbindung von Deckelteil und Kastenunterteil im Bereich einer Trennfuge, bei der eine Verbindungsklammer des Kastenunterteiles und ein Klammerverbinder des Deckelteiles in einem Längsschnitt auf nur einer Kastenseite dargestellt sind.

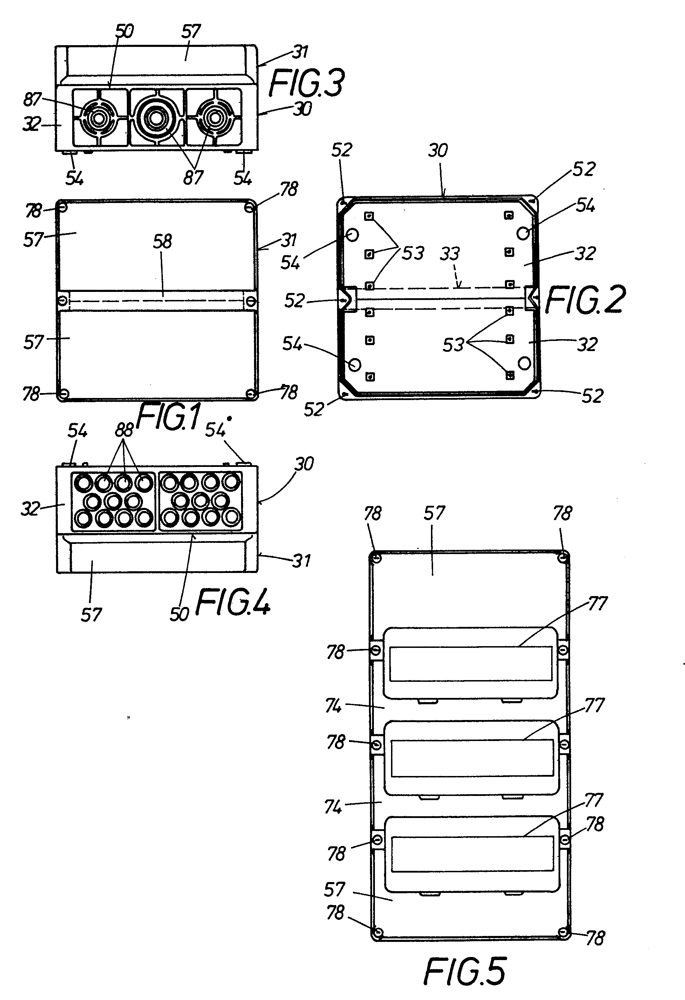

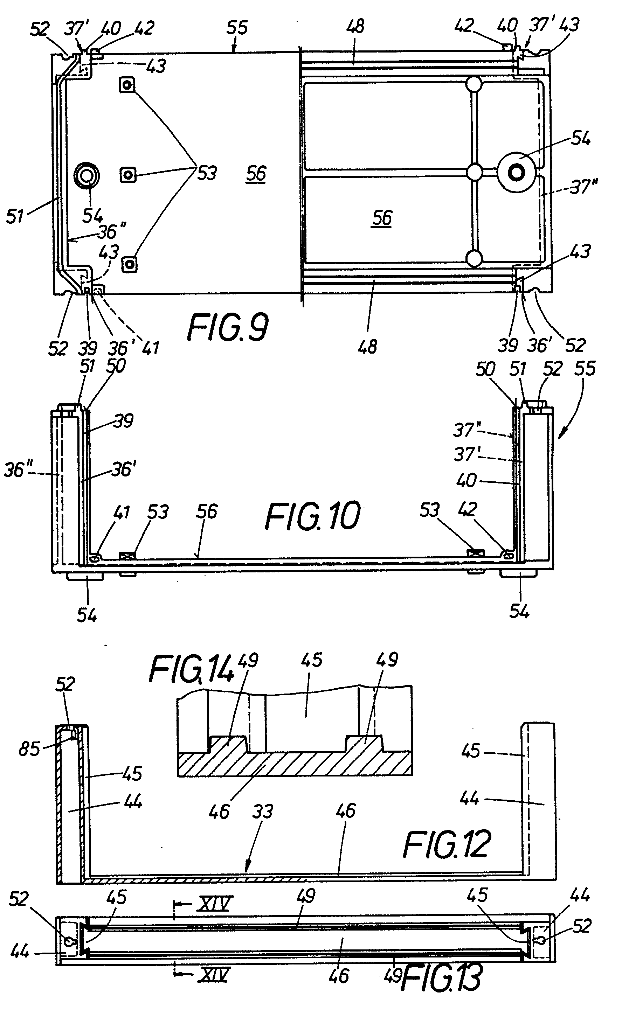

Der aus den Fig. 1 bis 4 ersichtliche Kasten besteht aus einem Kastenunterteil 30 und einem Deckelteil 31. Dabei ist der Kastenunterteil aus zwei Endstücken 32 gebildet, die von einer U-förmigen Verbindungsklammer 33 zusammengehalten sind. Jedes Endstück 12 weist einen aussenseitig verrippten Boden 34 auf, der an drei Seiten von den Wandungen 35, 36 und 37 umfasst ist. Während die Wandungen 36 und 37 auf einer Seite mit der Wandung 35 zwei rechtwinklige Ecken 38 bildend miteinander verbunden sind, gehen die anderen Seiten der Wandungen 36 und 37 in jeweils eine winklige nach innen zurückspringende Stosswandung 36' und 37' über. Die Stosswandungen 36' und 37' bilden zusammen mit der bis zu den Stosswandungen vorgezogenen Bodenkante eine Trennebene. Wie insbesondere den Fig. 7 und 8 entnommen werden kann, weist die Stosswandung 36' eine Dichtnut 39 und die Stosswandung 37' eine Dichtleiste 40 auf. Im Eckbereich zwischen der Stosswandung 36' und dem Boden 34 ist eine Passaufnahme 41 angeordnet, während im Eckbereich zwischen der Stosswandung 37' und dem Boden 34 ein Passvorsprung 42 vorgesehen ist. Im Bereich der Trennfuge weisen die winklig zurückspringenden Wandungen 36 und 37 jeweils einen Halbtrapezquerschnitt aufweisende Halteleistenhälften 43 auf. Bei dem aus den Fig. 1 bis 4 ersichtlichen Ausführungsbeispiel sind zwei Endstücke 32 zu dem Kastenunterteil 30 zusammengefügt, da ein gegenüber dem in Fig. 8 dargestellten Endstück um 180° gedrehtes zweites Endstück mit seiner Dichtleiste 40 und seinem Passvorsprung 42 in die Dichtnut 39 und die Passaufnahme 41 hineinpasst. Diese Verbindungslage wird gesichert durch die Verbindungsklammer 33. Die im Bereich der Trennfuge winklig zurückspringenden Wandungen 36 und 37 der zusammengefügten Endstücke 32 bilden einen über die Höhe der Wandungen 36 und 37 verlaufenden, etwa rechteckförmigen, vom Boden 34 her zugänglichen Freiraum, in den die Schenkel 44 der aus den Fig. 12 bis 14 ersichtlichen Verbindungsklammer 33 eingesteckt werden können. Die röhrenartigen Schenkel 44 der Verbindungsklammer 33 sind oberseitig geschlossen und weisen auf ihrer einander zugekehrten Innenseite jeweils über ihre volle Länge eine schwalbenschwanzartige Klemmnut 45 auf. Die Unterseiten beider Schenkel 44 sind über einen Steg 46 derart miteinander verbunden, dass sich die gesamte Verbindungsklammer von der Unterseite her mit ihren Klemmnuten 45 auf die Halteleistenhälften 43 der Endstücke 32 aufstecken lassen. Die Bodenunterseite jedes Endstückes 32 weist im Trennfugenbereich einen Rücksprung 47 von der Stärke des Steges 46 der Verbindungsklammer 33 auf. In diesem Rücksprung befindet sich ausserdem eine parallel zur Trennfuge verlaufende Nut 48, in die eine von zwei Federn 49 am Steg 46 der Verbindungsklammer 33 schliessend eingreift. Bei zwei zusammengefügten Endstücken 32 greifen in die beiden Nuten 48 jeweils die beiden Federn 49 der Verbindungsklammer 33 ein und können durch beispielsweise Kleben oder Ultraschallschweissung fest mit den Endstücken 32 verbunden sein. An dem die Trennebene 50 zwischen dem Kastenunterteil 30 und dem Deckelteil 31 bildenden Oberrand des Deckelteiles 31 ist ein umlaufender Federvorsprung 51 an den Ecken 38 und im Bereich der Trennfuge zwischen zwei Endstücken 32 derart geführt, dass im Oberrand an den Ecken 38 und im äusseren Bereich der Trennfuge ein Freiraum zur Anordnung von Schlüssellöchern 52 vorhanden ist. Im Oberrand des Endstücks 32 ist in der Trennfuge ein halbes Schlüsselloch vorgesehen, das durch das halbe Schlüsselloch des angrenzenden Endstückes 32 ergänzt wird. Ein derartiges Schlüsselloch 52, das sich mit den Schlüssellochhälften im Oberrand des Endstückes 32 deckt, findet sich auch in der Oberwandung der Schenkel 44 der Verbindungsklammer 33. Während auf der Innenseite des Bodens 34 des Endstücks 32 Anschlusswarzen 53 zur Aufnahme von Geräteträgern vorgesehen sind, sind auf der Unterseite jedes Endstücks 32 im Eckbereich Befestigungsaugen 54 mit ausbrechbaren Wandteilen zum Durchtritt einer Befestigungsschraube vorgesehen.

Zur Vergrösserung des Kastenunterteiles 30 ist gemäss den Fig. 9 und 10 ein zwischen die Endstücke 32 passendes Zwischenstück 55 vorgesehen. Dieses Zwischenstück 55 stimmt im Prinzip von der Form her mit dem Endstück 32 überein. Diesem Zwischenstück 55 fehlt, seiner Aufgabe entsprechend, die Wandung 35 und es weist im wesentlichen einen U-förmigen Querschnitt auf, wobei an den Boden 56 eines Zwischenstückes 55 auf einander gegenüberliegenden Seiten Wandungen 36″ und 37″ anschliessen, die im Bereich der Trennfugen des Zwischenstücks in winklig zurückspringende Stosswandungen 36′ und 37′ münden. Auch bei dem Zwischenstück 55 weisen die Stosswandungen 36′ eine senkrecht zum Boden 56 verlaufende Dichtnut 39 und im Eckbereich zwischen der Stosswandung 36″ und dem Boden 56 eine Passaufnahme 41 auf, während auf den jeweils gegenüberliegenden Seiten die Stosswandung 37′ eine Dichtleiste 40 und einen Passvorsprung 42 im Bereich des Bodens 56 aufweist. Am Zwischenstück 55 ist an jedem seiner vier senkrecht verlaufenden Eckbereiche durch die winklig zurückspringenden Wandungen 36″ und 37″ ein Aufnahmeraum gebildet, in den ebenfalls nach aussen eine halbtrapezförmige, über die Höhe der Wandungen 36″ und 37″ verlaufende Halteleistenhälfte 43 vorspringt. Gleichfalls ist im Boden 56 im Bereich beider Trennfugen eine von Wandung 36″ und Wandung 37″ auf der Unterseite des Bodens 56 verlaufende Nut 48 angeordnet, in welche ebenfalls eine Feder 49 der Verbindungsklammer 33 eingreifen kann, wenn diese vollständig in den Freiraum im Bereich der Trennfuge, die Halteleistenhälften 43, aneinandergrenzender Zwischenstücke bzw. eines mit einem Endstück zusammengefügten Zwischenstücks übergreifend, eingeschoben ist. Auch bei dem Zwischenstück 55 springt aus dem die Trennebene 50 bildenden Oberrand der Wandungen 36″ und 37″ ein Federvorsprung 51 vor, dessen Zweck später noch erläutert werden wird. Innenseitig weist das Zwischenstück 55 ebenfalls Anschlusswarzen 53 für die Befestigung von Geräteträgern bzw. der Geräte selbst auf. Auch sind im Boden 56 eines jeden Zwischenstücks 55 im mittleren Bereich in der Nähe der Wandungen 36″ und 37″ Befestigungsaugen 54 angeordnet, die der späteren Festlegung des Kastenunterteiles an einer Wand oder dgl. dienen. Ausserdem sind auch im Trennfugenbereich des Zwischenstückes halbe Schlüssellöcher 52 in der den Freiraum abdeckenden Wandung angeordnet.

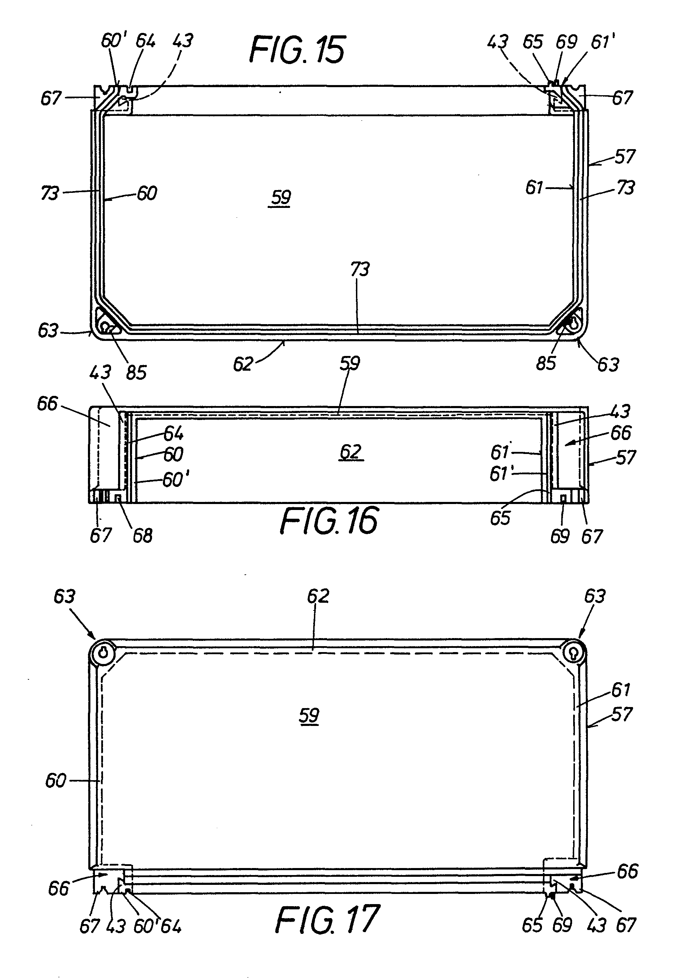

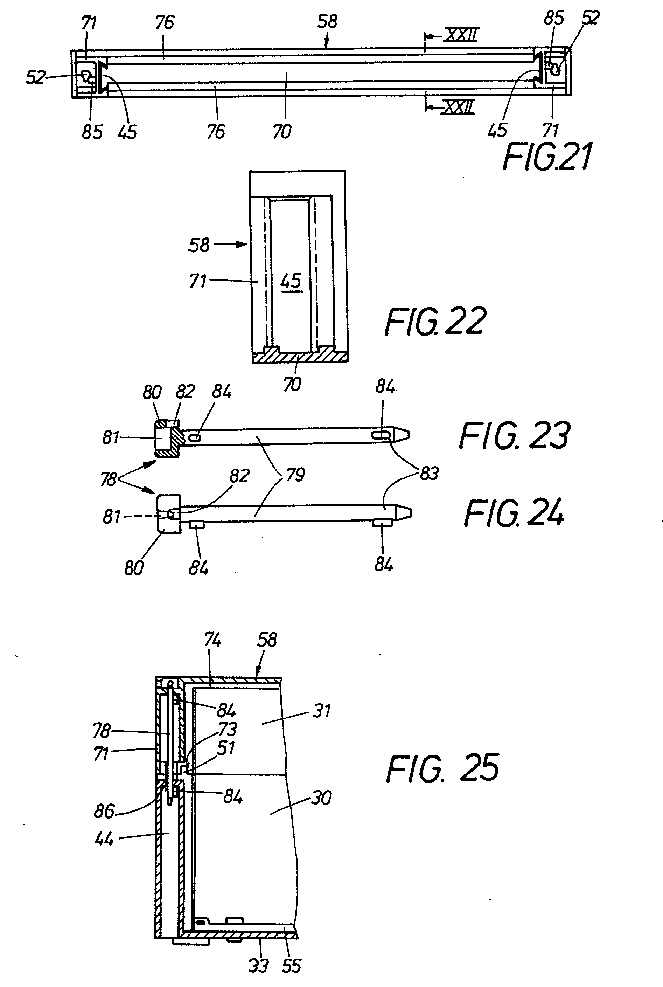

In Ergänzung zum Kastenunterteil 30 lässt sich der Deckelteil 31 mit ähnlich gestalteten Bauelementen aufbauen. In den Fig. 15 bis 17 ist eine Endschale 57 des Deckelteils dargestellt, die auf das Endstück 32 des Kastenunterteiles 30 passt. Bei dem aus den Fig. 1 bis 4 ersichtlichen Kasten besteht der Deckelteil 31 aus zwei Endschalen 57, die von einem U-förmigen Klammerverbinder 58 zusammengehalten sind. Jede Endschale 57 weist eine Deckelwand 59 auf, die auf drei Seiten von den Wandungen 60, 61 und 62 umfasst ist. Die beiden einstückig mit der Deckelwand 59 verbundenen Wandungen 60 und 61 gehen in jeweils einer Ecke 63 in die ebenfalls mit der Deckelwand 59 einstückig verbundene Wandung 62 über. Die anderen Seiten der Wandungen 60 und 61 bilden ebenfalls, wie bei den Endstücken 32, winklig nach innen zurückspringende Stosswandungen 60′ und 61′. Diese Stosswandungen 60′ und 61′ bilden zusammen mit der bis zur Höhe der Stosswandungen vorgezogenen Deckelwand 59 eine Trennebene. Aus den Fig. 15 bis 17 ist ersichtlich, dass die Stosswandung 60′ eine Dichtnut 64 aufweist, während die Stosswandung 61 eine in dieser Dichtnut passende Dichtleiste 65 aufweist. Der durch die abgewinkelten Stosswandungen 60′ und 61′ gebildete Fugenfreiraum 66 ist im Bereich der Trennebene 50 zwischen dem Deckelteil und dem Kastenunterteil durch einen Wandungslappen 67 überbrückt. In dem sich an die Stosswandung 60′ anschliessenden Wandungslappen 67 ist neben der Dichtnut 64 eine Passaufnahme 68 angeordnet, während der sich an die Stosswandung 61′ anschliessende Wandungslappen 67 einen in die Passaufnahme 68 passenden Passvorsprung 69 aufweist. Auch bei der Endschale 57 weisen die winklig zurückspringenden Wandungen eine in den Fugenfreiraum 66 vorragende, ebenfalls einen Halbtrapezquerschnitt aufweisende Halteleistenhälfte 43 auf. Auch der Deckelteil des aus den Fig. 1 bis 4 ersichtlichen Kastens ist durch zwei Endschalen 57 gebildet, da eine gegenüber der in Fig. 15 dargestellten Endschale um 180° gedrehte zweite Endschale mit ihrer Dichtleiste 65 in die Dichtnut 64 und mit ihrem Passvorsprung 69 in die Passaufnahme 68 der anderen Endschale 57 hineinpasst. Diese Verbindungslage wird ähnlich, wie bei dem Kastenunterteil durch einen Klammerverbinder 58 gesichert. Auch der aus den Fig. 21 bis 22 ersichtliche Klammerverbinder 58 weist aus seinem Steg 70 hohlkörperartige Schenkel 71 auf, die ebenfalls mit aufeinander zu nach innen weisenden schwalbenschwanzförmigen Klemmnuten 45 versehen sind, mit welchen die Halteleistenhälften der beiden zusammengefügten Endschalen 57 in ihrer Verbindungslage gesichert werden. Auch die Deckelwand 69 weist zwischen den beiden Fugenfreiräumen 66 eine parallel zur Trennfuge verlaufende Nut 72 auf, in die eine der beiden Leisten 73 am Steg 70 des Klammerverbinders 58 im Verbindungszustand eingreifen kann und, wie bereits oben bei der Verbindungsklammer 33 erwähnt, beispielsweise durch Kleben oder Schweissen fest mit der Endschale 57 verbindbar ist. Der Rand über den Wandungen 60, 61 und 62 der Endschale 57 weist eine umlaufende Nut 73 auf, in welche eine Dichtschnur eingelegt werden mag, so dass im zusammengesetzten Zustand von Deckelteil und Kastenunterteil der in die Nut 73 eingreifende Federvorsprung 51 des Endstückes 32 eine vollständige Abdichtung des Kasteninnenraumes bewirken mag.

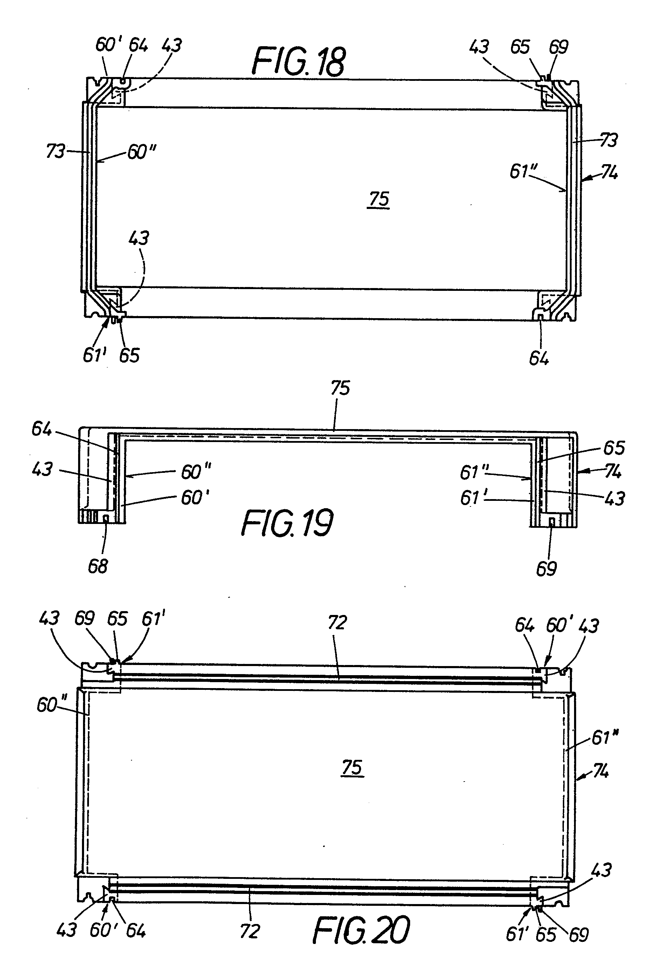

Aber auch der Deckelteil 31 ist durch eine Zwischenschale 74 erweiterungsfähig. Dabei entspricht die Zwischenschale 74 in ihrem Aufbau im wesentlichen der Endschale 57, wobei jedoch die Wandung 62 der Endschale 57 bei der Zwischenschale fehlt und beide Trennfugenbereiche gleich ausgebildet sind. Die in den Fig. 18 bis 20 dargestellte Zwischenschale 74 weist einen im wesentlichen U-förmigen Querschnitt auf, wobei aus der Deckwand 75 die Wandungen 60″ und 61″ senkrecht vorragen, wie insbesondere aus Fig. 19 ersichtlich ist. Diese im Trennfugenbereich ebenfalls abgewinkelten Wandungen 60″ und 61″ bilden ebenfalls Stosswandungen 60′ und 61′, wobei in der Stosswandung 60′ ebenfalls eine Dichtnut 64 und eine Passaufnahme 68 angeordnet ist. Aus der Stosswandung 61′ springt einerseits eine Dichtleiste 65 und andererseits ein Passvorsprung 69 vor, wobei der Passvorsprung 69 in die Passaufnahme 68 und die Dichtleiste 65 in die Dichtnut 64 einer angrenzenden Endschale 57 oder einer weiteren angrenzenden Zwischenschale 74 passt. Auch in den durch die Abwinklung der Wandungen 60″ und 61″ gebildeten Fugenfreiraum ragt eine halbtrapezförmige Halteleistenhälfte 43 vor, die zusammen mit einer Halteleistenhälfte einer angrenzenden Endschale 57 oder einer weiteren angrenzenden Zwischenschale 74 von der Klemmnut 45 im Schenkel 71 des Klammerverbinders 58 umfasst werden kann. Die Deckwand 75 der Zwischenschale 74 ist ähnlich, wie der Boden 56 des Zwischenstücks 55, zurückgesetzt und weist jeweils eine zu den beiden Trennfugen parallel verlaufende Nut 72 auf, in welche eine der beiden Federn 76 im Steg der Klammerverbinder 58 im Verbindungszustand eingreifen kann. Der Klammverbinder 58 wird von der Oberseite her auf die zu verbindenden Endschalen 57 bzw. Endschale und Zwischenschale oder zwei Zwischenschalen 74 gedrückt und legt sich mit der Aussenseite des Steges bündig an die Aussenseite der Deckwand 75 an. Auch der die Trennebene bildende Rand der Wandungen 60″ und 61″ weist eine Nut 73 auf, in welche der Federvorsprung 51 des Zwischenstückes 55 passt.

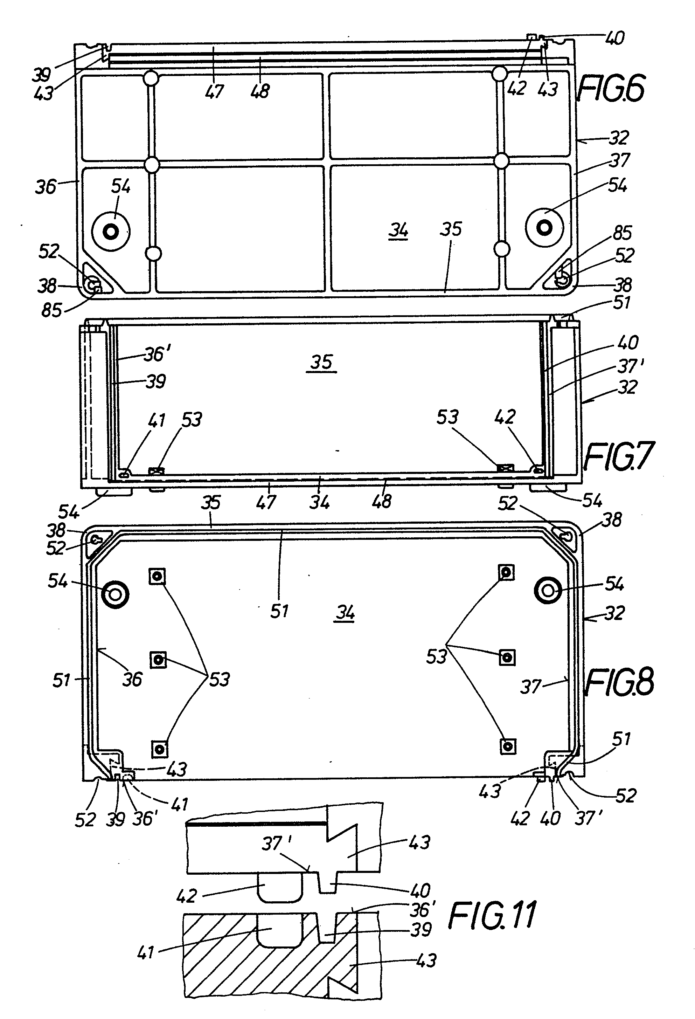

Die Endschalen 57 und die Zwischenschalen 74 können aus einem durchsichtigen Werkstoff hergestellt sein, um einen Blick auf das Innere des Kastens freizugeben. Wenn jedoch der Blick ausschliesslich nur auf die Automaten oder die Sicherungen freigegeben werden soll, lässt sich, wie insbesondere aus Fig. 5 ersichtlich ist, jede Endschale 57 und jede Zwischenschale 74 im Trennfugenbereich mit einem Halbausschnitt versehen, der sich durch das Aneinanderfügen der Endschalen 57 bzw. der Zwischenschale 74 zu einer Sichtöffnung 77 ergänzt. Bei dem aus Fig. 5 ersichtlichen Ausführungsbeispiel werden zwei Endschalen 57 zusammen mit zwei Zwischenschalen 74 zu einem Deckelteil ergänzt, wobei der Kastenunterteil ebenfalls aus zwei Endstücken 32 und zwei Zwischenstücken 55 gebildet ist. Es versteht sich, dass bei der Verwendung von Endschalen 57 und Zwischenschalen 74 mit einem eine Sichtöffnung 77 bildenden Halbausschnitt der Klammverbinder 58 keinen Steg 70 aufweisen kann, so dass auf jeder Seite des Deckelteiles 31 nur ein Klammerverbinder bestehend aus dem Schenkel 71 eingesetzt werden kann.

Zur Verbindung des Kastenunterteiles 30 mit dem Deckelteil 31 werden Schnellverbindungskopfbolzen 78 verwendet, die einen zylindrischen Schaft 79 und einen zylindrischen Kopf 80 aufweisen. Im Kopf 80 des Schnellverbindungskopfbolzens ist ein Schlitz 81 eingetieft, der über eine Seitenausnehmung 82 im Kopf eine Öffnung nach aussen hin aufweist. Mit geringem Abstand unterhalb des Kopfes 80 ist am Schaft 79 sowie an dessen Ende 83 je ein Schlüsselnocken 84 in einstückiger Verbindung mit dem Schaft 79 angeordnet. Unterhalb eines jeden Schlüsselloches 52 an den Ecken 38 des Endstücks 32 bzw. den Ecken 63 der Endschale 57 sind Anschläge 85 angeordnet, um die zunächst in den Deckelteil eingesteckten und verschwenkten Schnellverbindungskopfbolzen in die Sperrbereitschaftslage zu bringen, während die Anschläge unter den Schlüssellöchern im Eckbereich des Endstücks 32 und die Anschläge 85 unter den Schlüssellöchern 52 in der Verbindungsklammer 33 dazu dienen, die Sperrposition des Schnellverbindungskopfbolzens zu markieren. Dabei sind die Schlüssellöcher 52 und die Anschläge 85 an den Ecken 38 des Endstücks 32 und die Schlüssellöcher 52 der Verbindungsklammern 33 gegenüber den Schlüssellöchern an den Ecken der Endschalen und deren Anschlägen 85 um 90° verdreht angeordnet. Unterhalb der die Schlüssellöcher aufweisenden Wandungen an den Ecken 38 der Endstücke 32 und unterhalb der die Schlüssellöcher 52 aufweisenden Wandteile der Verbindungsklammer 33 sind als Gewindegangsektor ausgebildete Stützflächen 86 angeordnet, die in Richtung auf die zugehörigen Anschläge 85 ansteigen.

In Fig. 25 ist die Verbindung zwischen dem Deckelteil 31 und dem Kastenunterteil 30 am Beispiel einer Passlage zwischen einer Zwischenschale 74 und einem Zwischenstück 55 dargestellt. Der Federvorsprung 51 des Zwischenstücks 55 fasst dabei in die Nut 73 der Zwischenschale 74. Die im Bereich der Trennfuge den Kastenunterteil 30 untergreifende Verbindungsklammer 33 ragt mit ihrem Schenkel 44 in den Fugenfreiraum zwischen zwei Zwischenstücken bzw. zwischen einem Zwischenstück und dem Endstück ein, während der den Deckelteil 31 übergreifende Klammerverbinder 58 in den Fugenfreiraum 66 zwischen zwei Zwischenschalen 74 bzw. zwischen einer Endschale 57 und einer Zwischenschale 74 eingreift. Der Schnellverbindungskopfbolzen untergreift mit seinem endschaftseitigen Schlüsselnocken 84 die Stützfläche 86 und liegt an dem aus Fig. 12 ersichtlichen Anschlag 85 der Verbindungsklammer 33 an.

Es sei noch darauf hingewiesen, dass in der Wandung 35 des Endstücks 32 die aus Fig. 3 ersichtlichen durchmessergrossen Einführöffnungen 87 für entsprechende Stromkabel angeordnet sein können. Durch Austausch eines Werkzeugteiles lassen sich jedoch auch in der Wandung 35 des Endstücks 32 die aus Fig. 4 ersichtlichen durchmesserkleineren, durch ausbrechbare Wandteile bildbaren Einführöffnungen 88 vorsehen.

Wie bereits erwähnt, geben die dargestellten Ausführungen die Erfindung nur beispielsweise wieder und diese ist keinesfalls allein darauf beschränkt. Es sind vielmehr noch mancherlei Änderungen und Ergänzungen der Erfindung möglich.

Bezugszeichenliste

| | |
|---|---|
| 30 | Kastenunterteil |
| 31 | Deckelteil |
| 32 | Endstück |
| 33 | Verbindungsklammer |
| 34 | Boden von 32 |
| 35 | Wandung von 32 |
| 36 | Wandung von 32 |
| 36' | Stosswandung |
| 36'' | Wandung von 55 |
| 37 | Wandung von 32 |
| 37' | Stosswandung |
| 37'' | Wandung von 55 |
| 38 | Ecke |
| 39 | Dichtnut |
| 40 | Dichtleiste |
| 41 | Passaufnahme |
| 42 | Passvorsprung |
| 43 | Halteleistenhälfte |
| 44 | Schenkel |
| 45 | Klemmnut |
| 46 | Steg |
| 47 | Rücksprung |
| 48 | Nut |
| 49 | Feder |
| 50 | Trennebene |
| 51 | Federvorsprung |
| 52 | Schlüsselloch |
| 53 | Anschlusswarze |
| 54 | Befestigungsauge |
| 55 | Zwischenstück |
| 56 | Boden |
| 57 | Endschale |
| 58 | Klammerverbinder |
| 59 | Deckelwand |
| 60 | Wandung von 57 |
| 60' | Stosswandung |
| 60'' | Wandung von 74 |
| 61 | Wandung von 57 |
| 61' | Stosswandung |
| 61'' | Wandung von 74 |
| 62 | Wandung von 57 |
| 63 | Ecke |
| 64 | Dichtnut |
| 65 | Dichtleiste |
| 66 | Fugenfreiraum |
| 67 | Wandungslappen |
| 68 | Passaufnahme |
| 69 | Passvorsprung |
| 70 | Steg von 58 |
| 71 | Schenkel von 58 |
| 72 | Nut in 59 |
| 73 | Nut |
| 74 | Zwischenschale |
| 75 | Deckwand |
| 76 | Feder |
| 77 | Sichtöffnung |
| 78 | Schnellverbindungskopfbolzen |
| 79 | Schaft |
| 80 | Kopf |
| 81 | Schlitz |
| 82 | Seitenausnehmung |
| 83 | Schaftende |
| 84 | Schlüsselnocken |
| 85 | Anschlag |
| 86 | Stützfläche |
| 87 | Einführöffnung |
| 88 | Einführöffnung |

**Patentansprüche**

1. Spritzwassergeschützter Kasten für elektrische Geräte, wie Automaten, Sicherungen, Klemmen und Stromzähler, der in Feuchträumen, wie Garagen und Waschanlagen, installierbar ist und im wesentlichen aus einem Kastenteil und einem Deckelteil besteht, wobei diese Kastenteile an der Verbindungsfuge mit Dichtleisten und Dichtungen ineinandergreifen, dadurch gekennzeichnet, dass sowohl der Kastenunterteil (30) als auch der Deckelteil (31) aus Endstücken (32) bzw. Endschalen (57) und ggf. Zwischenstücken (55) bzw. Zwischenschalen (74) gebildet ist, die über Verbindungsklammern (33) bzw. Klammerverbinder (58) zusammengesetzt sind, wobei die Verbindungsklammern (33) bzw. die Klammerverbinder (58) U-förmig gestaltet sind und den Kastenunterteil (30) bzw. den Deckelteil (31) an den Stossfugen überdecken, indem die mit Klemmnuten (45) versehenen Schenkel (44, 71) der Verbindungsklammern (33) bzw. Klammerverbinder (58) über die Höhe des Kastenunterteiles (30) bzw. des Deckelteiles (31) verlaufende Halteleistenhälften (43) zusammenhalten, während der die Schenkel verbindende Steg (46, 70) mit den Endstücken (32) bzw. Endschalen (57) und den Zwischenstücken (55) bzw. Zwischenschalen (74) durch Schweissen oder Kleben fest verbindbar ist.

2. Kasten nach Anspruch 1, dadurch gekennzeichnet, dass die Endstücke (32) und die Zwischenstücke (55) des Kastenunterteiles (30) auf einer Seite Passvorsprünge (42) und Dichtleisten (40) und auf der anderen Seite Passaufnahmen (41) und Dichtnuten (39) an ihrer die Trennfuge bildenden Stosswandung (36', 37') aufweisen, während auch die Endschalen (57) und die Zwischenschalen (74) des Deckelteiles auf einer Seite ebenfalls Passvorsprünge (69) und Dichtleisten (65) und auf der anderen Seite Passaufnahmen (68) und Dichtnuten (64) an ihrer die Trennfuge bildenden Stosswandung aufweisen.

3. Kasten nach Anspruch 1, dadurch gekennzeichnet, dass die Halteleistenhälften (43) einen Halbtrapezquerschnitt aufweisen und die Klemmnuten (45) der Verbindungsklammern (33) zur Umklammerung zweier Halteleistenhälften (43) schwalbenschwanzartig gestaltet sind.

4. Kasten nach einem oder mehreren der vorhergehenden Ansprüche, dadurch gekennzeichnet, dass in der Trennebene (50) zwischen Deckelteil (31) und Kastenunterteil (30) an jedem Endstück (32) und Zwischenstück (55) ein Federvorsprung (51) angeordnet ist, der in eine Nut (73) in der Trennebene jeder Endschale (57) und der Zwischenschale (74) passt.

5. Kasten nach einem oder mehreren der vorhergehenden Ansprüche, dadurch gekennzeichnet, dass die den Deckelteil bildenden Endschalen (57) und Zwischenschalen (74) jeweils einen sich zu einer Sichtöffnung (77) ergänzenden Halbausschnitt aufweisen, die durch eine durchsichtige Klappe abgedichtet abdeckbar ist.

6. Kasten nach Anspruch 5, dadurch gekennzeichnet, dass die Klammerverbinder für die eine Sichtöffnung bildenden Endschalen (57) und Zwischenschalen (74) eigenständige, steglose Schenkelstücke (71) darstellen.

7. Kasten nach einem oder mehreren der vorhergehenden Ansprüche, dadurch gekennzeichnet, dass das Kastenunterteil (30) mit dem Deckelteil (31) über Schnellverbindungskopfbolzen (78) verbindbar ist, wobei die Schnellverbindungskopfbolzen unterhalb ihres Kopfes (80) und am Schaftende (83) je einen Schlüsselnocken (84) aufweisen.

8. Kasten nach Anspruch 7, dadurch gekennzeichnet, dass an den Ecken (63) eines Kastens in dessen Deckelteil (31) Schlüssellöcher (52) angeordnet sind und auch die Klammerverbinder (58) Schlüssellöcher (52) aufweisen, die gegenüber den Schlüssellöchern im Kastenunterteil (30) und in den Verbindungsklammern (33) um 90° versetzt sind.

9. Kasten nach den Ansprüchen 7 und 8, dadurch gekennzeichnet, dass die die Schlüssellöcher (52) aufweisenden Wandteile unterseitig mit Anschlägen (85) versehen sind und die den am Schaftende des Schnellverbindungskopfbolzens sitzenden Schlüsselnocken (84) übergreifenden Wandbereiche des Kastenunterteiles (30) und der Verbindungsklammern (33) eine als Gewindegangsektor ausgebildete Stützfläche (86) aufweisen.

## Claims

1. A splashproof box for electrical appliances, such as automatic machines, fuses, terminals and current meters, adapted to be installed in humid spaces such as garages and washing plants, and substantially consisting of a box part and a cover part, these box parts interlacing at the connecting joint with sealing strips and seals, characterized in that both the lower box part (30) and also the cover part (31) are formed by end pieces (32) resp. end cups (57) and, if necessary, intermediate pieces (55) resp. intermediate cups (74), which are joined together via connecting clamps (33) resp. clamp connectors (58), the connecting clamps (33) resp. clamp connectors (58) being of U-shape and overlapping the lower box part (30) resp. the cover part (31) at the but joints in that the legs (44, 71) of the connecting clamps (33) resp. clamp connectors (58), provided with clamping grooves (45), hold together holding strip halves (43) extending over the height of the lower box part (30) resp. cover part (31), while the web (46, 70) interconnecting the legs is rigidly connectable with the end pieces (32) resp. end cups (57) and the intermediate pieces (55) resp. intermediate cups (74) as by welding or glucing.

2. A box as claimed in the claim 1, characterized in that the end pieces (32) and the intermediate pieces (55) of the lower box part (30) on the one side have fitting projections (42) and sealing strips (40) and on the other side fitting seats (41) and sealing grooves (39) on the but wall (36', 37') constituting the partition line, while also the end cups (57) and the intermediate cups (74) of the cover part on the one side also have fitting projections (69) and sealing strips (65) and on the other side fitting seats (68) and sealing grooves (64) on their but wall constituting the partition line.

3. A box as claimed in the claim 1, characterized in that the holding strip halves (43) are of semi-trapezoidal cross-section and the clamping grooves (45) of the connecting clamps (33) for embracing two holding strip halves (43) are designed to be dovetailed.

4. A box as claimed in any one or several of the preceding claims, characterized in that in the parting plane (50) between cover part (31) and box part (30) on each end piece (32) and intermediate piece (55) there is provided a spring projection (51) which fits in a groove (73) in the parting plane of each end cup (57) and intermediate cup (74).

5. A box as claimed in any one or several of the preceding claims, characterized in that the end cups (57) and intermediate cups (74) forming the cover part are provided with a semi-recess each, combining to form a viewing opening (77) which can be sealingly covered by a transparent cap.

6. A box as claimed in the claim 5, characterized in that the clamp connectors for the end cups (57) and intermediate cups (74) forming a viewing opening represent independent webless leg pieces (71).

7. A box as claimed in any one or several of the preceding claims, characterized in that the lower box part (30) is connectable to the cover part (31) via quick-connecting setbolts (78), the quick-connecting setbolts having below their head (80) and at the shaft end (83) one key cam (84) each.

8. A box as claimed in the claim 7, characterized in that at the corners (63) of a box there are provided keyholes (52) in the cover part (31) thereof and also the clamp connectors (58) have keyholes (52) which are offset by 90° relative to the keyholes in the lower box part (30) and in the connecting clamps (33).

9. A box as claimed in the claims 7 and 8, characterized in that the wall portions which have the keyholes (52) are provided on the underside with stops (85) and the wall areas of the lower box part, gripping over the key cam (84) located at the shaft end of the quick-connecting setbolt, and of the connecting clamps (33) have a support surface designed as thread sector (86).

**Revendications**

1. Armoire, protégée contre les projections d'eau, pour des appareils électriques tels que des automates, des fusibles, des bornes et des compteurs électriques, qui peut être installée dans des pièces humides comme des garages et des buanderies et qui se compose, dans l'essentiel, d'une partie d'armoire et d'une partie de couvercle, ces parties d'armoire s'emboîtant l'une dans l'autre dans les zones de jonction au moyen de moulures et de joints d'étanchéité, caractérisée en ce qu'aussi bien la partie inférieure d'armoire (30) que la partie de couvercle (31) sont constituées de pièces d'extrémité (32) ou bien de coquilles d'extrémité (57) et, le cas échéant, de pièces intermédiaires (55) ou de coquilles intermédiaires (74), qui sont maintenues assemblées par l'intermédiaire d'attaches de liaison (33) ou bien d'éléments de liaison d'attache (58), les attaches de liaison (33) ou bien les éléments de liaison d'attache (58) étant profilées en forme de U et recouvrant la partie inférieure d'armoire (30) ou bien la partie de couvercle dans les joints de butée, par le fait que les branches (44, 71) pourvues de rainures de blocage (45), des attaches de liaison (33) ou des éléments de liaison d'attache (58) maintiennent assemblées des moitiés de moulure de retenue (43) s'étendant sur la hauteur de la partie inférieure d'armoire (30) ou de la partie de couvercle (31), tandis que le voile (46, 70) reliant les branches peut être relié solidement par soudage ou par collage avec les pièces d'extrémité (32) ou les coquilles d'extrémité (57) et les pièces intermédiaires (55) ou les coquilles intermédiaires (74).

2. Armoire selon la revendication 1, caractérisée en ce que les pièces d'extrémité (32) et les pièces intermédiaires (55) de la partie inférieure d'armoire (30) comportent d'un côté des saillies d'adaptation (42) et des moulures d'étanchéité (40) et, de l'autre côté, des évidements d'adaptation (41) et des rainures d'étanchéité (39) dans leurs parois de butée (36', 37') formant les attaches de liaison, tandis qu'également les coquilles d'extrémité (57) et les coquilles intermédiaires (74) de la partie de couvercle comportent, d'un côté, également des saillies d'adaptation (69) et des moulures d'étanchéité (65) et, de l'autre côté, des évidements d'adaptation (68) et des rainures d'étanchéité (64) dans leurs parois de butée formant les attaches de liaison.

3. Armoire selon la revendication 1, caractérisée en ce que les moitiés de moulure de retenue (43) ont une section droite en forme de demi-trapèze et les rainures de blocage (45) des attaches de liaison (33) sont profilées en forme de queue d'aronde en vue d'un assemblage de deux moitiés de moulure de retenue (43).

4. Armoire selon une quelconque des revendications précédentes, caractérisée en ce qu'il est prévu, dans le plan de séparation (50), entre la partie de couvercle (31) et la partie inférieure d'armoire (30), sur chaque pièce d'extrémité (32) et sur chaque pièce intermédiaire (55), une saillie élastique (51) qui vient s'emboîter dans une rainure (73) située dans le plan de séparation de chaque coquille d'extrémité (57) et de la coquille intermédiaire (74).

5. Armoire selon une ou plusieurs des revendications précédentes, caractérisée en ce les coquilles d'extrémité (57) et les coquilles intermédiaires (74) formant la partie de couvercle comportent, chacune, une demi-ouverture pouvant être complétée par une autre pour former une ouverture d'observation (77) qui peut être recouverte de façon étanche par un clapet transparent.

6. Armoire selon la revendication 5, caractérisée en ce que les éléments de liaison d'attache pour les coquilles d'extrémité (57) et les coquilles intermédiaires (74) formant une ouverture d'observation, représentent des pièces à branches sans âme et indépendantes (71).

7. Armoire selon une ou plusieurs des revendications précédentes, caractérisée en ce que la partie inférieure d'armoire (30) peut être reliée à la partie de couvercle (31) par l'intermédiaire de broches à tête de liaison rapide (78), les broches à tête de liaison rapide comportant, en-dessous de leur tête (80) et à l'extrémité (83) de leur tige, respectivement un taquet de clé (84).

8. Armoire selon la revendication 7, caractérisée en ce qu'il est prévu dans les coins (63) d'une armoire et dans sa partie de couvercle (31) des trous de clé (52) et en ce qu'également les éléments de liaison d'attache (58) comportent des trous de clé (52), qui sont décalés de 90° par rapport aux trous de clé ménagés dans la partie inférieure d'armoire (30) et dans les attaches de liaison (33).

9. Armoire selon les revendications 7 et 8, caractérisée en ce que les parties de paroi comportant les trous de clé (52) sont pourvues, sur leur côté inférieur, de butées (85) et les zones de paroi de la partie inférieure d'armoire (30) et des attaches de liaison (33) qui s'accrochent sur les taquets de clé (84) prévus à l'extrémité de tige de la broche à tête de liaison rapide comportent une surface d'appui (86) en forme de secteur de portée de filetage.

FIG.3

FIG.2

FIG.1

FIG.4

FIG.5

FIG.6

FIG.7

FIG.8

FIG.11

0 062 135

FIG.9

FIG.10

FIG.14

FIG.12

FIG.13

13

FIG.15

FIG.16

FIG.17

FIG.18

FIG.19

FIG.20

**FIG.21**

**FIG.22**

**FIG. 23**

**FIG. 24**

**FIG. 25**